# FASCICULE DE BREVET EUROPEEN

(11) **EP 0 749 126 B1**
(45) Date de publication et mention de la délivrance du brevet: **16.08.2000**
(21) Numéro de dépôt: 96401228.0
(22) Date de dépôt: 07.06.1996
(51) Int. Cl.: G11C 7/00, G11C 11/409

(54) **Dispositif d'interfaçage de sortie programmable parmi trois états pour mémoire en technologie CMOS**
Programmierbares Schnittstellengerät für CMOS-Speicher mit drei Zuständen
Tri-state programmable output interface device for CMOS memory

(30) Priorité: 12.06.1995 FR 9506915
(43) Date de publication de la demande: 18.12.1996
(73) Titulaire: MHS, 44087 Nantes Cédex 03 (FR)
(72) Inventeur: Gerber, Rémi, 44300 Nantes (FR); Silloray, Janick, 44300 Nantes (FR)
(74) Mandataire: Fréchède, Michel

(56) Documents cités:
- EP-A- 0 368 524
- US-A- 5 067 109
- US-A- 5 295 098

## Description

L'invention concerne un dispositif d'interfaçage de sortie programmable parmi trois états pour mémoire en technologie CMOS.

Un tel dispositif est décrit par exemple dans le document EP-A-0 368 524. Celui-ci comprend en particulier, successivement en cascade :
- un étage de commande sélective recevant un signal d'entrée et un signal de commande, et permettant d'engendrer en sortie soit un état haute impédance quand le signal de commande est à la tension d'alimentation, soit le signal d'entrée quand le signal de commande est à la tension de référence,
- un étage réducteur d'écart analogique permettant d'engendrer en sortie un signal dont l'écart analogique, représentatif d'une impulsion de bruit, est réduit, et
- un étage de sortie recevant les signaux délivrés par l'étage réducteur d'écart analogique.

L'inconvénient de ce dispositif réside dans le fait que son fonctionnement manque de souplesse. En particulier, ce dispositif n'est pas adapté pour autoriser un découplage de l'étage de sortie des ports de sortie de l'étage réducteur analogique. Or, une telle fonction pourrait s'avérer intéressante lorsque l'étage de sortie est par exemple constitué par une mémoire, un tel découplage permettant de placer ainsi le dispositif d'interfaçage de sortie en état de sortie haute impédance et de réaliser les fonctions spécifiques d'écriture dans la mémoire.

La présente invention a pour objet la mise en oeuvre d'un dispositif d'interfaçage de sortie programmable parmi trois états pour mémoire en technologie CMOS permettant de résoudre cet inconvénient.

Un autre objet de la présente invention est la mise en oeuvre d'un tel dispositif d'interfaçage dans lequel le bruit de commutation de courant est en outre réduit.

Un autre objet de la présente invention est la mise en oeuvre d'un tel dispositif d'interfaçage sous forme de circuit intégré pour lequel la taille physique est réduite au minimum, l'implantation sur le substrat de silicium étant en outre facilitée en raison de la simplicité du schéma de réalisation.

Un autre objet de la présente invention est la mise en oeuvre d'un tel dispositif d'interfaçage dans lequel le choix des paramètres dimensionnels des transistors CMOS utilisés permet en fait un contrôle très souple des conditions de fonctionnement de ce dernier.

Le dispositif d'interfaçage de sortie programmable parmi trois états pour mémoire en technologie CMOS selon l'invention est alimenté à partir d'une tension d'alimentation par rapport à une tension de référence. Il est remarquable en ce qu'il comprend successivement en cascade :
- un étage de commande sélective du dispositif d'interfaçage recevant un signal d'entrée et un signal de commande, délivrés par la mémoire, permettant d'engendrer sur deux ports de sortie, soit des signaux logiques complémentés du signal d'entrée, soit des niveaux logiques distincts permettant d'engendrer un état haute impédance en sortie dudit dispositif d'interfaçage ;
- un premier étage inverseur recevant les signaux logiques délivrés par les deux ports de sortie de l'étage de commande permettant d'engendrer sur une première et une deuxième sortie des premiers signaux logiques inversés ;
- un deuxième étage inverseur recevant les premiers signaux logiques inversés et permettant d'engendrer sur une première et une deuxième sortie des deuxièmes signaux inversés ;
- un étage de sortie recevant les signaux délivrés par les première et deuxième sorties du deuxième étage inverseur, ledit étage de sortie délivrant un signal de sortie permettant de fixer et équilibrer le courant de charge et de décharge de la capacité électrique de sortie du dispositif d'interfaçage ;
- un étage réducteur d'écart analogique des deuxièmes signaux inversés et de commutation en sortie du dispositif d'interfaçage en état haute impédance ;
ledit étage réducteur d'écart analogique recevant les signaux délivrés par les première et deuxième sorties du deuxième étage inverseur et permettant, sur commande, d'abaisser la valeur de la tension du signal délivré par ladite première sortie du deuxième étage inverseur et d'augmenter la valeur de la tension du signal délivré par ladite deuxième sortie du deuxième étage inverseur.

Il trouve application à la réalisation de mémoires en technologie CMOS, sous forme de circuit intégré.

Une description plus détaillée du dispositif d'interfaçage de sortie programmable parmi trois états pour mémoire en technologie CMOS, objet de la présente invention, sera maintenant donnée en liaison avec les dessins dans lesquels :
- la figure 1 représente un schéma général du dispositif d'interfaçage de sortie programmable parmi trois états pour mémoire en technologie CMOS, objet de l'invention ;
- la figure 2 représente un schéma des capacités et inductances parasites d'un dispositif d'interfaçage selon l'invention, réalisé sous forme de circuit intégré ;
- les figures 3a, 3b et 3c représentent des chronogrammes de signaux relevés aux points de test des figures 1 et 2.

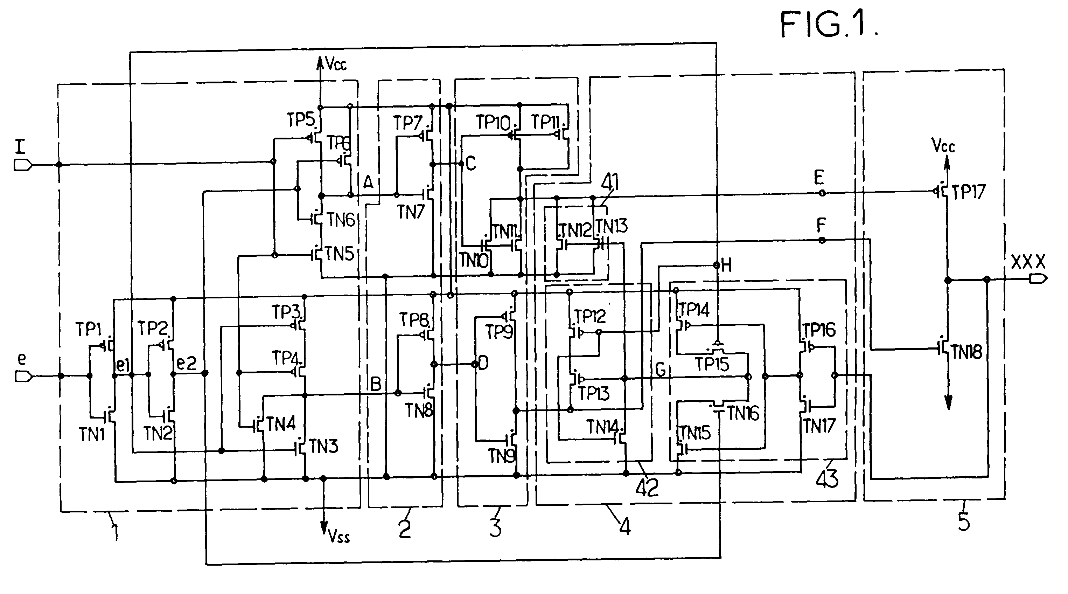

Une description plus détaillée d'un dispositif d'interfaçage de sortie programmable parmi trois états pour mémoire en technologie CMOS, conforme à l'objet de la présente invention, sera maintenant donnée en liaison avec la figure 1.

Selon la figure précitée, le dispositif objet de l'invention est alimenté par une tension d'alimentation, notée Vcc, par rapport à une tension de référence Vss.

Il comprend successivement, connectés en cascade, un étage 1 de commande sélective du dispositif d'interfaçage, cet étage de commande recevant un signal d'entrée I et un signal de commande e délivrés par la mémoire. D'une manière générale, on indique que le signal d'entrée I est constitué par un signal rectangulaire à la fréquence bit représentatif de données lues par exemple dans la mémoire et destinées à des circuits extérieurs de traitement de ces données, ces circuits extérieurs étant interconnectés à la mémoire par l'intermédiaire du dispositif d'interfaçage objet de la présente invention.

L'étage 1 de commande sélective permet d'engendrer, sur deux ports de sortie portant les références A respectivement B, soit des signaux logiques complémentés du signal d'entrée I, soit des niveaux logiques distincts permettant d'engendrer un état haute impédance en sortie du dispositif d'interfaçage ainsi qu'il sera décrit ultérieurement dans la description.

L'étage 1 de commande sélective est suivi d'un premier étage inverseur, portant la référence 2, lequel reçoit les signaux logiques délivrés par les deux ports de sorties A, B de l'étage de commande 1. Le premier étage inverseur 1 permet d'engendrer sur une première et une deuxième sortie, portant les références C, D, des premiers signaux logiques inversés correspondants.

Le premier étage inverseur 2 est suivi d'un deuxième étage inverseur 3, lequel reçoit les premiers signaux logiques inversés et permet d'engendrer sur une première et une deuxième sortie, notées E, F, des deuxièmes signaux inversés. Le deuxième étage inverseur 3 est lui-même suivi d'un étage 4 réducteur d'écart analogique des deuxièmes signaux inversés précités et de commutation en sortie du dispositif d'interfaçage en état haute impédance. Enfin, l'étage 4 réducteur d'écart analogique est lui-même suivi d'un étage 5 de sortie recevant les signaux délivrés par l'étage réducteur d'écart analogique 4 précité, après réduction d'écart des signaux délivrés aux bornes E et F précédemment mentionnées, l'étage de sortie 5 délivrant ainsi un signal de sortie, noté XXX, permettant de fixer et équilibrer le courant de charge et de décharge de la capacité électrique de sortie du dispositif d'interfaçage.

Avant de poursuivre plus avant la description du dispositif d'interfaçage objet de la présente invention, on indique que la capacité électrique de sortie de ce dispositif d'interfaçage est constituée non seulement par la capacité électrique propre de sortie du dispositif d'interfaçage, mais également de la capacité d'entrée de tout dispositif interconnecté au niveau de la borne de sortie de ce dispositif d'interfaçage et recevant le signal de sortie XXX précédemment mentionné.

D'une manière générale, on indique que l'étage réducteur d'écart analogique des deuxièmes signaux inversés et de commutation en sortie du dispositif d'interfaçage en état haute impédance permet de conférer au dispositif d'interfaçage de sortie objet de la présente invention, son caractère programmable parmi trois états, le caractère programmable de ce dispositif d'interfaçage résultant du fait que sur commande spécifique de l'étage réducteur d'écart analogique des deuxièmes signaux inversés, l'identité ou la quasi-identité des deuxièmes signaux inversés délivrés aux bornes de sortie E et F de cet étage réducteur d'écart permet un fonctionnement de type classique pour le dispositif d'interfaçage de sortie, objet de la présente invention, celui-ci délivrant alors le signal logique correspondant au signal d'entrée I correspondant aux deux états logiques classiques à la fréquence bit et représentatifs des données véhiculées par le signal d'entrée I.

Au contraire, sur commande spécifique de ce même étage réducteur d'écart analogique des deuxièmes signaux inversés, le dispositif d'interfaçage, objet de la présente invention, permet, par le forçage des signaux délivrés par les bornes de sortie E, F à des valeurs distinctes, à titre d'exemple non limitatif, la valeur permanente de la tension d'alimentation Vcc respectivement la valeur permanente de la tension de référence Vss, de découpler électriquement l'étage de sortie 5 proprement dit des bornes de sortie E,F de l'étage réducteur d'écart analogique 4, ce qui permet de placer ainsi le dispositif d'interfaçage de sortie en état de sortie haute impédance et de réaliser les fonctions spécifiques d'écriture dans la mémoire ainsi découplée du dispositif d'utilisation.

Le mode opératoire de la commande de la sortie deux états, respectivement de la sortie haute impédance, est basé, pour ce qui concerne le fonctionnement en sortie deux états, sur une contre-réaction du signal de sortie XXX sur l'étage 4 réducteur d'écart analogique, alors que le fonctionnement du dispositif d'interfaçage en sortie haute impédance est basé sur une commande spécifique du même étage 4 réducteur d'écart analogique à partir du signal de commande e, ainsi qu'il sera décrit ultérieurement dans la description.

Une description plus détaillée d'un mode de réalisation particulier avantageux de l'étage de commande 1, du premier et du deuxième étage inverseur 2, 3, de l'étage 4 réducteur d'écart analogique et de l'étage de sortie 5 sera maintenant donnée en liaison avec la même figure 1.

On comprend bien sûr que le mode de réalisation précité peut avantageusement être réalisé lui-même en technologie CMOS, ce qui permet bien entendu d'implanter directement le dispositif d'interfaçage de sortie programmable parmi trois états, objet de la présente invention, au niveau du circuit mémoire lui-même.

Selon la figure 1 précitée, on indique que l'étage de commande 1 comprend avantageusement un premier inverseur comprenant un transistor PMOS TP₁ et un transistor NMOS TN₁ connectés en cascade entre la tension d'alimentation et la tension de référence Vss. Les deux transistors précités sont commandés en parallèle par le signal de commande e et délivrent au niveau de leur électrode drain-source commune un premier signal de commande inversé, noté e₁.

En outre, un deuxième inverseur est prévu, lequel comprend un transistor PMOS TP₂ et un transistor NMOS TN₂ connectés en cascade entre la tension d'alimentation Vcc et la tension de référence Vss. Ces deux transistors sont également commandés en parallèle par le premier signal de commande inversé e₁. Ils délivrent au niveau de leur électrode drain-source commune un deuxième signal de commande inversé, noté e₂.

Ainsi que représenté sur la figure 1, l'étage 1 de commande comprend en outre un premier module inverseur du signal d'entrée I comprenant un transistor PMOS TP₅, un transistor NMOS TN₆ et un transistor NMOS TN₅ connectés en cascade entre la tension d'alimentation Vcc et la tension de référence Vss. En outre, un transistor PMOS TP₆ est connecté en parallèle avec le transistor PMOS TP₅, et l'électrode de grille commune des transistors PMOS TP₅ et NMOS TN₅ reçoit le signal d'entrée I. L'électrode de grille commune des transistors PMOS TP₆ et NMOS TN₆ reçoit le deuxième signal de commande inversé e₂ et le point commun drain-source des transistors PMOS TP₅, TP₆ et NMOS TN₆ constitue l'un des ports de sortie, le port de sortie A de l'étage de commande 1.

En outre, un deuxième module inverseur du signal d'entrée I comprend deux transistors PMOS TP₃, TP₄, et un transistor NMOS TN₃ connectés en cascade entre la tension d'alimentation et la tension de référence Vss. Un transistor NMOS TN₆ est en outre connecté en parallèle avec le transistor NMOS TN₄, et l'électrode de grille commune des transistors PMOS TP₃ et NMOS TN₃ reçoit le premier signal de commande inversé e₁. L'électrode de grille commune des transistors PMOS TP₄ et NMOS TN₄ reçoit le signal d'entrée I et le point commun drain-source des transistors PMOS TP₄ et NMOS TN₄, TN₃ constitue l'autre port de sortie, le port de sortie B de l'étage de commande 1.

Le fonctionnement de l'étage de commande 1 est le suivant : le signal d'entrée I, grâce à l'étage de commande 1 et en fonction du signal de commande e, permet au signal d'entrée I de commander ou non la partie suivante. En effet, si le signal de commande e est à la valeur de la tension d'alimentation Vcc, les ports de sortie A et B sont au niveau logique de I mais complémentés. Si le signal de commande e est à la valeur de la tension de référence Vss, alors, le port de sortie A est maintenu à une tension égale à la tension d'alimentation Vcc et le port de sortie B est à la valeur de la tension de référence Vss. Ce dernier état permet de positionner la sortie du dispositif d'interfaçage objet de la présente invention en état haute impédance, ainsi qu'il sera décrit ci-après dans la description.

En ce qui concerne le premier étage inverseur 2 et en référence à la figure 1, on indique que celui-ci comprend un premier module inverseur formé par un transistor PMOS TP₇ et un transistor NMOS TN₇ connectés en cascade, entre la tension d'alimentation Vcc et la tension de référence Vss. L'électrode de grille commune des transistors précités est interconnectée au port de sortie A du premier module inverseur de l'étage de commande 1, et le point commun drain-source des transistors PMOS TP₇ et NMOS TN₇ délivre les signaux logiques complémentés des signaux logiques délivrés par le port de sortie A du premier module inverseur de l'étage de commande 1.

Le premier étage inverseur 2 comporte en outre un deuxième module inverseur formé par un transistor PMOS TP₈ et un transistor NMOS TN₈ connectés en cascade, entre la tension d'alimentation et la tension de référence, l'électrode de grille commune de ces transistors étant interconnectée au port de sortie B du deuxième module inverseur de l'étage de commande 1. Le point commun drain-source des transistors PMOS TP₈ et NMOS TN₈ délivre les signaux logiques complémentés des signaux logiques délivrés par le port de sortie B du deuxième module inverseur de l'étage de commande 1.

Ainsi, le point commun drain-source des transistors PMOS et NMOS TP₇, TN₇, point C sur la figure 1, et le point commun drain-source des transistors PMOS TP₈ et NMOS TN₈, point D sur la figure 1, délivrent les premiers signaux logiques inversés qui ne sont autres que les valeurs complémentées des signaux aux ports de sortie A et B précédemment mentionnés dans la description.

En ce qui concerne le deuxième étage inverseur 3, celui-ci comprend, ainsi que représenté sur la figure 1, un premier module inverseur formé par deux transistors PMOS TP₁₀, TP₁₁, connectés en parallèle et deux transistors NMOS TN₁₀, TN₁₁, également connectés en parallèle, les transistors PMOS TP₁₀, TP₁₁ respectivement TN₁₀, TN₁₁ formant chacun un ensemble de transistors en parallèle, chaque ensemble étant connecté en cascade entre la tension d'alimentation Vcc et la tension de référence Vss.

Les électrodes de grille communes des transistors PMOS et NMOS précités reçoivent les signaux logiques complémentés, c'est-à-dire les premiers signaux logiques inversés délivrés par la borne C de sortie du premier module inverseur du premier étage inverseur 2. Le point commun drain-source de chaque ensemble de transistors en parallèle TP₁₀, TP₁₁ ; TN₁₀, TN₁₁, connectés en cascade, constitue la première sortie du deuxième étage inverseur 3.

Le deuxième étage inverseur 3 comporte également un deuxième module inverseur formé par un transistor PMOS TP₉ et un transistor NMOS TN₉ connectés en cascade entre la tension d'alimentation et la tension de référence Vss.

L'électrode de grille commune des transistors PMOS et NMOS précités reçoit les signaux logiques complémentés délivrés par la borne B du deuxième module inverseur du premier étage inverseur 2, et le point commun drain-source des transistors PMOS et NMOS précités, TP₉, TN₉, constitue une deuxième sortie du deuxième étage inverseur 3.

Du point de vue du fonctionnement, on indique que le deuxième inverseur 3 permet de complémenter les valeurs des signaux logiques délivrés aux bornes C et D du premier étage inverseur en des valeurs complémentées délivrées aux bornes de sortie précitées. Ces bornes de sortie du deuxième étage inverseur 3 sont notées E et F, la même notation que relativement aux bornes de sortie de l'étage réducteur d'écart analogique 4 étant utilisée en raison du fait que les sorties correspondantes sont en liaison directe, ainsi que représenté sur la figure 1.

En ce qui concerne l'étage réducteur d'écart de niveau analogique, ainsi que représenté sur la figure précitée, celui-ci comprend, avantageusement, un premier module de commutation connecté en parallèle entre la première sortie E du deuxième étage inverseur 3 et la tension de référence Vss. Ce module de commutation permet, sur commande de mise en conduction de celui-ci, d'abaisser la valeur de la tension analogique du signal délivré par la première borne de sortie E précitée.

En outre, un deuxième module de commutation est connecté en parallèle entre la deuxième sortie du deuxième étage inverseur F et la tension d'alimentation Vcc. Le deuxième module de commutation permet ainsi, sur commande de mise en conduction de celui-ci, d'augmenter la valeur de la tension de sortie de la deuxième sortie du deuxième module inverseur à la valeur de la tension d'alimentation Vcc.

L'étage 4 réducteur d'écart de niveau analogique comprend également un module 43 de commande de commutation du premier 41 et du deuxième 42 module de commutation, ce module 43 de commande de commutation opérant en contre-réaction du signal de sortie XXX et permettant la commande de commutation sensiblement simultanée du premier 41 et du deuxième 42 module de commutation.

Ce mode opératoire permet, soit de réduire le niveau analogique du signal délivré par la première sortie E du deuxième étage inverseur 3, soit d'augmenter la vitesse de décharge de la capacité électrique de sortie lors d'une transition du signal de sortie de la valeur de la tension d'alimentation Vcc à la tension de référence Vss, ou encore de positionner l'étage de sortie 5 en sortie à haute impédance.

D'une manière plus spécifique, on indique que le module 43 de commande comporte un inverseur formé par deux transistors PMOS TP₁₆ et NMOS TN₁₇ connectés en cascade entre la tension d'alimentation Vcc et la tension de référence Vss. Les électrodes de grille communes des transistors PMOS et NMOS précités sont connectées en sortie de l'étage de sortie 5 et reçoivent ainsi le signal de sortie XXX. Le point drain-source commun des transistors précités TP₁₆et TN₁₇ délivre un signal de sortie inversé.

Le module 43 de commande comporte également un circuit de commutation formé par deux transistors PMOS TP₁₄, TP₁₅ et deux transistors NMOS TN₁₅, TN₁₆ connectés en cascade entre la tension d'alimentation Vcc et la tension de référence Vss. Les électrodes de grille communes des transistors PMOS TP₁₄ et NMOS TN₁₅ reçoivent le signal de sortie inversé délivré par le point commun drain-source des transistors TP₁₆, TN₁₇. Les transistors PMOS TP₁₅ et NMOS TN₁₆ reçoivent sur leur électrode de grille le premier e₁ respectivement le deuxième e₂ signal de commande inversé. Le point commun drain-source entre les transistors PMOS TP₁₅ et NMOS TN₁₆, point commun référencé G sur la figure 1, permet de délivrer le signal de commande de commutation sensiblement simultanée du premier 41 et du deuxième 42 moyen de commutation de l'étage réducteur d'écart de niveau analogique 4.

Enfin, un transistor NMOS TN_{T4}, lequel est connecté entre le point commun drain-source entre les transistors PMOS TP₁₅ et NMOS TN₁₆ et la tension de référence Vss, est en outre prévu. L'électrode de grille du transistor NMOS TN₁₄ reçoit le premier signal de commande inversé e₁.

Le mode opératoire de l'étage réducteur d'écart de niveau analogique 4 a pour effet de réduire, au sens analogique, l'amplitude de tension sur la borne E de sortie de l'étage réducteur d'écart analogique 4 et, au contraire, d'augmenter la valeur de la tension sur la borne de sortie F de ce même étage lors d'une commutation de la sortie, c'est-à-dire du signal de sortie XXX, de la valeur de la tension d'alimentation Vcc à la valeur de la tension de référence Vss lors du fonctionnement du dispositif d'interfaçage, objet de la présente invention, dans le mode à deux états logiques.

C'est précisément à ce moment-là qu'il est nécessaire de réduire la pente de commutation du signal de sortie XXX car celle-ci entraîne un rebondissement du signal de sortie après sa commutation vers la tension de référence Vss et une oscillation pseudo-périodique des tensions d'alimentation de référence ramenées au niveau des puces du circuits intégré.

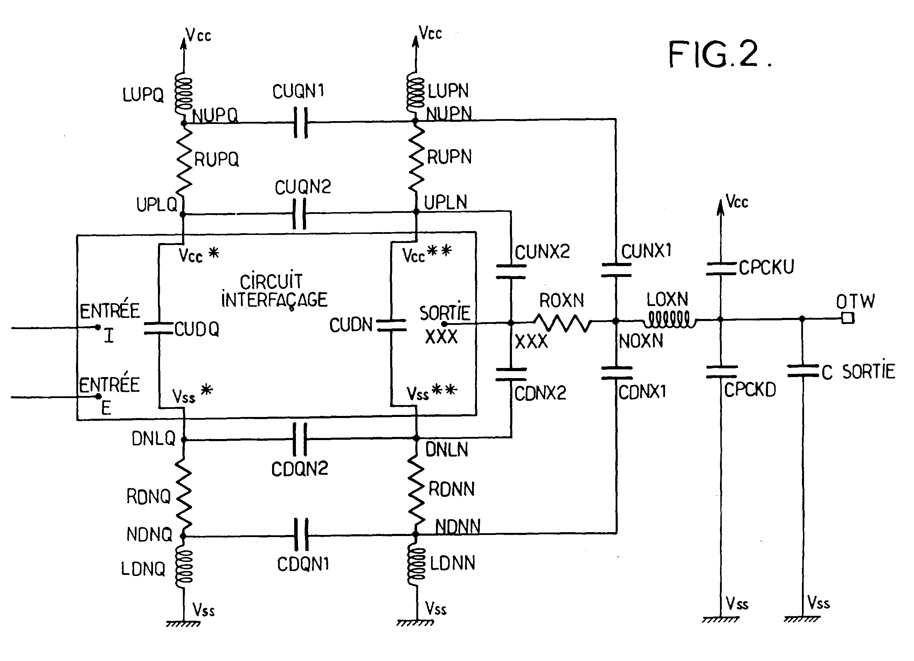

Ainsi que représenté de manière schématique sur la figure 2, on indique que ces oscillations pseudo-périodiques sont dues à la présence du boîtier, lequel est connecté au circuit d'interfaçage selon l'invention et contient des connexions métalliques qui présentent les inductances de fuites désignées sur la figure 2 précitée par LUPQ, LUPN, LOXN, LDNN et LDNQ.

En outre ces connexions sont couplées entre elles par couplage capacitif dû à la proximité physique de ces dernières, ces connexions présentant en outre une certaine résistance électrique fonction de leur longueur et de leur section. Les couplages capacitifs et les résistances correspondantes sont notées, sur la figure 2, RUPQ, RUPN, CUQN₁, CUQN₂, CUNX₂, CUNX₁, CDNX₂, CDNX₁, ROXN, RDNN, RDNQ, CDQN₂, CDQN₁, CPCKU et CPCKD. La capacité de sortie est désignée par Csortie. En outre, les notations Vcc* et Vss* désignent les tensions d'alimentation respectivement de référence disponibles sur le BUS de données (Vcc rail et Vss rail) lorsque ces valeurs de tension sont couplées par la capacité parasite CUDQ, les notations Vcc** et Vss** les tensions d'alimentation respectivement de référence disponibles sur les transistors périphériques tampon TP₁₇ et TN₁₈ lorsque ces tensions sont couplées par la capacité parasite CUDN.

La commutation du signal de sortie XXX de la valeur de la tension d'alimentation Vcc vers la valeur de la tension de référence Vss est la plus critique car les seuils de commutation vers la tension de référence sont plus réduits que leurs équivalents vers la tension d'alimentation Vcc. En conséquence, une oscillation pseudo-aléatoire sur les alimentations Vss est susceptible de provoquer des commutations imprévues dans le dispositif d'interfaçage selon l'invention, en raison du fait que la tension de référence Vss constitue une référence pour la tension grille-source de tous les transistors NMOS.

Ainsi, la contre-réaction réalisée entre la sortie de l'étage de sortie 5, délivrant le signal de sortie XXX, et le module de commande de commutation 43 de l'étage de réduction d'écart analogique 4 sur les niveaux des signaux délivrés par les bornes E et F de sortie de ce même étage 4, permet de faire conduire les transistors NMOS TN₁₂ et TN₁₃ afin de réduire le niveau analogique du signal présent sur la borne de sortie E lorsque le signal de sortie XXX passe de la valeur de la tension d'alimentation Vcc à la valeur de la tension de référence Vss. Un tel mode opératoire a pour effet de faire conduire le transistor PMOS TP₁₇ suffisamment pour ralentir la vitesse de décharge du condensateur de sortie Csortie, mais toutefois de manière suffisamment réduite afin de ne pas trop faire augmenter la consommation dynamique en énergie électrique du dispositif d'interfaçage objet de la présente invention.

En ce qui concerne la borne de sortie F de ce même étage de réduction d'écart analogique 4, plus l'amplitude du signal de sortie XXX descend vers la valeur de la tension de référence Vss et plus la tension sur la borne de sortie F monte vers la valeur de la tension d'alimentation Vcc, grâce à l'action du deuxième module de commutation 42, c'est-à-dire de la branche composée par les transistors PMOS TP₁₂ et TP₁₃. Ce processus a pour conséquence d'accélérer la vitesse de décharge du condensateur de sortie Csortie lorsque le signal de sortie XXX approche, au sens analogique du terme, la valeur du niveau de la tension de référence Vss lors de sa commutation de la valeur de la tension d'alimentation Vcc à la valeur de la tension de référence Vss.

En ce qui concerne la commutation en état haute impédance, on indique que le transistor NMOS TN₁₄ joue un rôle spécifique, celui-ci permettant de conserver la valeur de la tension à la borne G, point commun drain-source des transistors TP₁₅ et TN₁₆, à la valeur de la tension de référence Vss lorsque le signal de commande e est à la valeur de la tension de référence Vss. En effet, lorsque la borne G est portée à la tension de référence Vss et dans le cas où le premier signal de commande inversé e₁ sur la borne H est à la valeur de la tension d'alimentation Vcc, les transistors PMOS TP₁₂ et les transistors NMOS TN₁₂ et TN₁₃ sont ouverts, les modules de commutation 41 et 42 étant alors en position commutée à l'ouverture, c'est-à-dire non conducteurs. Par voie de conséquence, la structure de contre-réaction est coupée lorsque le signal sur la borne E est à la valeur de la tension de référence Vss. Dans ce cas, les bornes de sortie E et F sont ainsi amenées aux valeurs de tension d'alimentation Vcc respectivement tension de référence Vss, ce qui permet de commander le découplage de l'étage de sortie 5 ainsi qu'il sera décrit ci-après en relation avec la figure 1.

L'étage de sortie 5 précité comporte un transistor PMOS TP₁₇ et un transistor NMOS TN₁₈ connectés en cascade entre la tension d'alimentation Vcc et la tension de référence Vss. Le point commun drain-source des transistors PMOS et NMOS précités constitue une borne de sortie pour l'étage de sortie et également la borne de sortie du dispositif selon l'invention. En outre, l'électrode de grille du transistor PMOS TP₁₇ est connectée à la première sortie du deuxième étage inverseur, et en définitive à la borne E de l'étage 4 réducteur d'écart analogique, et l'électrode de grille du transistor NMOS TN₁₇ est elle-même connectée à deuxième sortie F du deuxième étage inverseur, c'est-à-dire en définitive à la borne F de sortie de l'étage 4 réducteur d'écart analogique.

On comprend ainsi que, lorsque les bornes de sortie E et F précitées sont portées respectivement à la valeur de la tension d'alimentation Vcc et de la tension de référence Vss, les transistors PMOS TP₁₇ et NMOS TN₁₈ sont désactivés, ce qui permet de placer la sortie en état de haute impédance ainsi que mentionné précédemment dans la description.

On comprend ainsi que l'étage de sortie 5 permet de fixer et d'équilibrer à l'aide des transistors TP₁₇ et TN₁₈ le courant de charge et de décharge de la capacité de sortie Csortie.

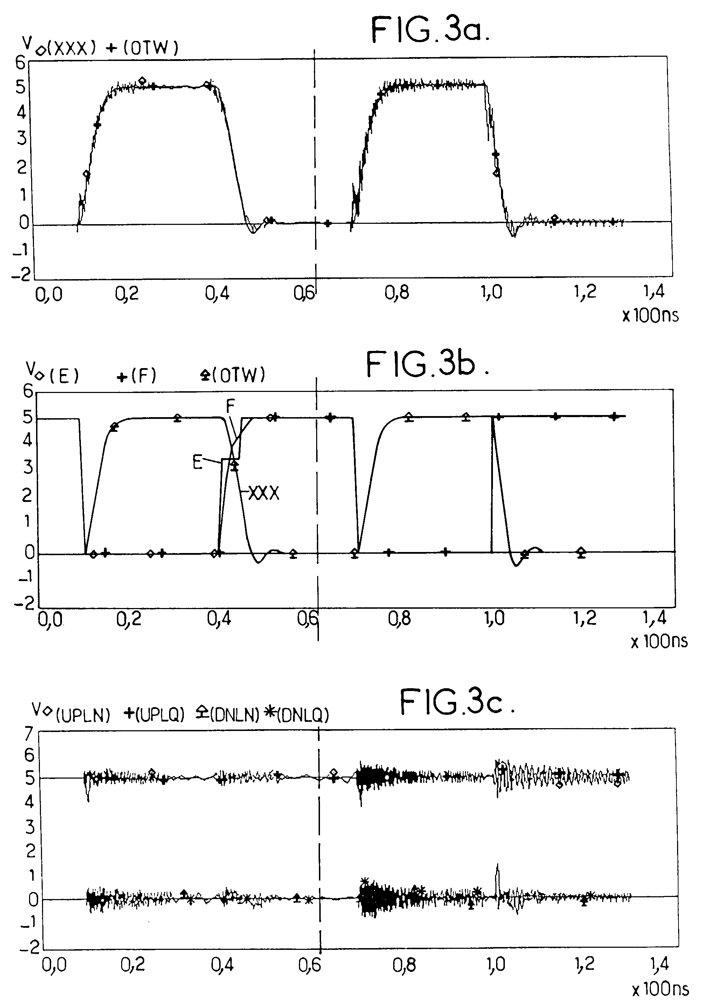

Sur la figure 3, on a représenté, en 3a, 3b et 3c, des chronogrammes représentatifs des signaux aux points de test tels que représentés en figure 1, respectivement en figure 2. Les chronogrammes sont représentés en partie gauche de chaque figure lorsque la boucle de contre-réaction réalisée entre la sortie de l'étage de sortie 5 et par l'intermédiaire des modules de commutation 41, 42 et du module de commande 43 de commutation est active, ce qui permet de réduire notoirement le niveau de bruit du signal de sortie, cette boucle de contre-réaction étant bien entendu active lorsque le dispositif d'interfaçage de sortie programmable parmi trois états, objet de la présente invention, fonctionne selon deux états logiques représentatifs du signal d'entrée I. On constate en particulier sur la figure 3a que, en l'absence de contre-réaction, la boucle étant ouverte, le niveau de bruit est très supérieur.

Sur la figure 3b, on a représenté dans les mêmes conditions de présence et d'absence de contre-réaction, les signaux obtenus sur la borne E respectivement sur la borne F ainsi que sur la capacité de sortie Csortie, le signal étant désigné V(OTW).

On constate que, en présence de contre-réaction et afin d'assurer le contrôle de la décharge de la capacité de sortie Csorties, le signal E est retardé légèrement par rapport au signal F, ce léger décalage permettant en particulier d'assurer la commande de la décharge de la capacité de sortie ainsi que mentionné précédemment dans la description. Ce décalage est suffisant pour assurer le contrôle du niveau de bruit tel que représenté en figure 3a, partie gauche, l'identité ou la quasi-identité des signaux obtenue sur les bornes E et F à la valeur du retard précité près, permettant toutefois d'assurer un fonctionnement du dispositif d'interfaçage de sortie programmable parmi trois états, objet de la présente invention, selon les deux états logiques représentatifs du signal d'entrée I ainsi que mentionné précédemment dans la description.

Au contraire, dans la partie droite de la figure 3b, c'est-à-dire en l'absence de contre-réaction, on constate que la montée en tension des ports E et F vers la valeur Vcc est quasi-instantanée, ce qui permet de placer le circuit d'interfaçage selon l'invention en son état logique bas sans contrôle du niveau de bruit.

Enfin, la figure 3c représente des chronogrammes enregistrés aux points UPLN, UPLQ, DNLN et DNLQ de la figure 2, c'est-à-dire au niveau des liaisons parasites du circuit d'interfaçage objet de la présente invention. On constate en particulier, par comparaison de la partie gauche et de la partie droite de la figure 3c, que le niveau de bruit, c'est-à-dire le niveau de tension aux points de test correspondants, est sensiblement diminué en présence de contre-réaction.

On a ainsi décrit un dispositif d'interfaçage de sortie programmable parmi trois états pour mémoire en technologie CMOS particulièrement performant dans la mesure où ce dispositif permet, non seulement de satisfaire les critères de bruit, mais également d'augmenter ou de diminuer la contre-réaction à souhait en altérant par exemple la taille et paramètres dimensionnels des transistors tels que les transistors TP₁₂, TP₁₃, TN₁₂ et TN₁₃ par exemple. Enfin, on indique que, en fonction du degré de contre-réaction introduit, le temps de propagation des signaux est augmenté en conséquence.

## Revendications

1. Dispositif d'interfaçage de sortie programmable parmi trois états pour mémoire en technologie CMOS, alimenté par une tension d'alimentation (Vcc) par rapport à une tension de référence (Vss), comprenant successivement en cascade :
- un étage de commande sélective dudit dispositif d'interfaçage recevant un signal d'entrée (I) et un signal de commande (e), délivrés par la mémoire, et permettant d'engendrer sur deux ports de sortie (A,B), soit des signaux logiques complémentés du signal d'entrée (I), soit des niveaux logiques distincts permettant d'engendrer un état haute impédance en sortie (XXX) dudit dispositif d'interfaçage ;
- un premier étage inverseur recevant les signaux logiques délivrés par les deux ports de sortie (A,B) de l'étage de commande permettant d'engendrer sur une première et une deuxième sortie (C,D) des premiers signaux logiques inversés ;
- un deuxième étage inverseur recevant les premiers signaux logiques inversés et permettant d'engendrer sur une première et une deuxième sortie (E,F) des deuxièmes signaux inversés ;
- un étage de sortie recevant les signaux délivrés par les première et deuxième sorties (E,F) du deuxième étage inverseur, ledit étage de sortie délivrant un signal de sortie (XXX) permettant de fixer et équilibrer le courant de charge et de décharge de la capacité électrique de sortie dudit dispositif d'interfaçage ;
- un étage réducteur d'écart analogique des deuxièmes signaux inversés et de commutation en sortie dudit dispositif d'interfaçage en état haute impédance ;
ledit étage réducteur d'écart analogique recevant les signaux délivrés par les première et deuxième sorties (E,F) du deuxième étage inverseur et permettant, sur commande, d'abaisser la valeur de la tension du signal délivré par ladite première sortie (E) du deuxième étage inverseur et d'augmenter la valeur de la tension du signal délivré par ladite deuxième sortie (F) du deuxième étage inverseur.

2. Dispositif selon la revendication 1, caractérisé en ce que ledit étage de commande comprend :
- un premier inverseur comprenant un transistor PMOS (TP₁) et un transistor NMOS (TN₁) connectés en cascade entre la tension d'alimentation (Vcc) et la tension de référence (Vss) et commandés en parallèle par le signal de commande (e), ces transistors délivrant au niveau de leur électrode drain-source commune un premier signal de commande inversé (e₁) ;
- un deuxième inverseur comprenant un transistor PMOS (TP₂) et un transistor NMOS (TN₂) connectés en cascade entre la tension d'alimentation (Vcc) et la tension de référence (Vss) et commandés en parallèle par le premier signal de commande inversé (e₁), ces transistors délivrant au niveau de leur électrode drain-source commune un deuxième signal de commande inversé (e₂) ;
- un premier module inverseur dudit signal d'entrée (I) comprenant un transistor PMOS (TP₅), un transistor NMOS (TN₆) et un transistor NMOS (TN₅) connectés en cascade entre la tension d'alimentation (Vcc) et la tension de référence (Vss), un transistor PMOS (TP₆) étant en outre connecté en parallèle avec ledit transistor PMOS (TP₅), l'électrode de grille commune des transistors PMOS (TP₅) et NMOS (TN₅) recevant ledit signal d'entrée (I) et l'électrode de grille commune des transistors PMOS (TP₆) et NMOS (TN₆) recevant ledit deuxième signal de commande inversé (e₂), le point commun (A) drain-source des transistors PMOS (TP₅, TP₆) et NMOS (TN₆) constituant l'un desdits ports de sortie de l'étage de commande ;
- un deuxième module inverseur dudit signal d'entrée (I) comprenant deux transistors PMOS (TP₃, TP₄) et un transistor NMOS (TN₃) connectés en cascade entre la tension d'alimentation (Vcc) et la tension de référence (Vss), un transistor NMOS (TN₄) étant en outre connecté en parallèle avec ledit transistor NMOS (TN₃), l'électrode de grille commune desdits transistors PMOS (TP₃) et NMOS (TN₃) recevant ledit premier signal de commande inversé (e₁) et l'électrode de grille commune des transistors PMOS (TP₄) et NMOS (TN₄) recevant ledit signal d'entrée (I), le point commun drain-source (B) des transistors PMOS (TP₄) et NMOS (TN₄, TN₃) constituant l'autre desdits ports de sortie de l'étage de commande.

3. Dispositif selon l'une des revendications 1 ou 2, caractérisé en ce que ledit premier étage inverseur comprend :
- un premier module inverseur formé par un transistor PMOS (TP₇) et un transistor NMOS (TN₇) connectés en cascade, l'électrode de grille commune desdits transistors étant interconnectée audit port de sortie du premier module inverseur de l'étage de commande, le point commun (C) drain-source desdits transistors PMOS (TP₇) et NMOS (TN₇) délivrant les signaux logiques complémentés des signaux logiques délivrés par ledit port de sortie du premier module inverseur de l'étage de commande ;
- un deuxième module inverseur formé par un transistor PMOS (TP₈) et un transistor NMOS (TN₈) connectés en cascade, l'électrode de grille commune desdits transistors étant interconnectée audit port de sortie du deuxième module inverseur de l'étage de commande et le point commun (D) drain-source desdits transistors PMOS (TP₈) et NMOS (TN₈) délivrant les signaux logiques complémentés des signaux logiques délivrés par ledit port de sortie du deuxième module inverseur de l'étage de commande.

4. Dispositif selon l'une des revendications 1 et 3, caractérisé en ce que ledit deuxième étage inverseur comprend :
- un premier module inverseur formé par deux transistors PMOS (TP₁₀, TP₁₁) connectés en parallèle et deux transistors NMOS (TN₁₀, TN₁₁) connectés en parallèle, chaque ensemble de transistors en parallèle étant connecté en cascade entre la tension d'alimentation (Vcc) et la tension de référence (Vss), les électrodes de grille commune desdits transistors PMOS et NMOS recevant les signaux logiques complémentés délivrés par le premier module inverseur du premier étage inverseur, le point commun (E) drain-source des ensembles de transistors en parallèle connectés en cascade constituant la première sortie du deuxième étage inverseur ;
- un deuxième module inverseur formé par un transistor PMOS (TP₉) et un transistor NMOS (TN₉) connectés en cascade entre la tension d'alimentation (Vcc) et la tension de référence (Vss), l'électrode de grille commune desdits transistors PMOS et NMOS recevant les signaux logiques complémentés délivrés par le deuxième module inverseur du premier étage inverseur, le point commun (F) drain-source desdits transistors PMOS et NMOS (TP9, TN9) constituant la deuxième sortie du deuxième étage inverseur.

5. Dispositif selon l'une des revendications 1 à 4, caractérisé en ce que ledit étage réducteur d'écart de niveau analogique comprend :
- des premiers moyens de commutation (41) connectés en parallèle entre la première sortie (E) du deuxième étage inverseur et la tension de référence (Vss), lesdits premiers moyens de commutation permettant, sur commande de mise en conduction de ces derniers, d'abaisser la valeur de la tension analogique du signal délivré par ladite première sortie (E) du deuxième étage inverseur ;
- des deuxièmes moyens de commutation (42) connectés en parallèle entre la deuxième sortie (F) du deuxième étage inverseur et la tension d'alimentation (Vcc), lesdits deuxièmes moyens de commutation permettant, sur commande de mise en conduction de ces derniers, d'augmenter la valeur de la tension de sortie de la deuxième sortie (F) du deuxième étage inverseur à la valeur de la tension d'alimentation (Vcc) ;
- des moyens de commande de commutation (43) desdits premier et deuxième moyens de commutation, en contre-réaction du signal de sortie (XXX), permettant la commande de commutation sensiblement simultanée desdits premier et deuxième moyens de commutation, ce qui permet, soit de réduire le niveau analogique du signal délivré par la première sortie (E) du deuxième étage inverseur, soit d'augmenter la vitesse de décharge de la capacité électrique de sortie lors d'une transition du signal de sortie de la valeur de la tension d'alimentation (Vcc) à la tension de référence ou encore de positionner ledit étage de sortie en sortie à haute impédance.

6. Dispositif selon la revendication 5, caractérisé en ce que lesdits moyens de commande (43) comportent :
- un inverseur formé par deux transistors PMOS (TP₁₆) et NMOS (TN₁₇) connectés en cascade entre la tension d'alimentation (Vcc) et la tension de référence (Vss), les électrodes de grille communes desdits transistors PMOS et NMOS étant connectées en sortie (XXX) dudit étage de sortie et recevant ladite tension de sortie, le point commun drain-source desdits transistors délivrant un signal de sortie inversé ;
- un circuit de commutation formé par deux transistors PMOS (TP₁₄, TP₁₅) et deux transistors NMOS (TN₁₅, TN₁₆) connectés en cascade entre la tension d'alimentation (Vcc) et la tension de référence (Vss), les électrodes de grille communes des transistors PMOS (TP₁₄) et NMOS (TN₁₅) recevant ledit signal de sortie inversé et les transistors PMOS (TP₁₅) et NMOS (TN₁₆) recevant sur leur électrode de grille le premier (e₁) respectivement le deuxième (e₂) signal de commande inversé, le point commun drain-source entre les transistors PMOS (TP₁₅) et NMOS (TN₁₆) permettant de délivrer ledit signal de commande de commutation sensiblement simultanée des premier et deuxième moyens de commutation de l'étage réducteur d'écart de niveau analogique ;
- un transistor NMOS (TN₁₄) connecté entre le point commun drain-source entre les transistors PMOS (TP₁₅) et NMOS (TN₁₆) et la tension de référence (Vss) dont l'électrode de grille reçoit ledit premier signal de commande inversé (E₁).

7. Dispositif selon l'une des revendications 1 à 6, caractérisé en ce que ledit étage de sortie comprend un transistor PMOS (TP₁₇) et un transistor NMOS (TN₁₈) connectés en cascade entre la tension d'alimentation (Vcc) et la tension de référence (Vss), le point commun drain-source desdits transistors PMOS et NMOS constituant une borne de sortie pour ledit étage de sortie et la borne de sortie dudit dispositif, l'électrode de grille dudit transistor PMOS (TP₁₇) étant connectée à ladite première sortie (E) dudit deuxième étage inverseur et l'électrode de grille dudit transistor NMOS (TN₁₇) étant connectée à ladite deuxième sortie (F) dudit deuxième étage inverseur.

## Patentansprüche

1. Zwischen drei Zuständen programmierbare Ausgangsschnittstellenvorrichtung für einen CMOS-Technologie-Speicher, welche Vorrichtung durch eine Versorgungsspannung (Vcc) bezüglich einer Bezugsspannung (Vss) versorgt wird und in Kaskade aufeinanderfolgend umfaßt:
- eine Stufezurselektiven Steuerung der Schnittstellenvorrichtung, welche Stufe vom Speicher geliefert ein Eingangssignal (I) und ein Steuersignal (e) empfängt und es ermöglicht, an zwei Ausgangsanschlüssen (A, B) entweder zum Eingangssignal (I) komplementierte Logiksignale oder unterschiedliche Logikpegel zu erzeugen, die die Erzeugung eines Hochimpedanzzustands am Ausgang (XXX) der Schnittstellenvorrichtung erlauben;
- eine erste Inverterstufe, die die von den zwei Ausgangsanschlüssen (A, B) der Steuerstufe gelieferten Logiksignale empfängt und die Erzeugung von ersten invertierten Logiksignalen an einem ersten und einem zweiten Ausgang (C, D) ermöglicht;
- eine zweite Inverterstufe, die die ersten invertierten Logiksignale empfängt und die Erzeugung von zweiten invertierten Signalen an einem ersten und einem zweiten Ausgang (E, F) ermöglicht;
- eine Ausgangsstufe, die die vom ersten und zweiten Ausgang (E, F) der zweiten Inverterstufe gelieferten Signale empfängt, wobei die Ausgangsstufe ein Ausgangssignal (XXX) liefert, welches das Festlegen und Abgleichen des Lade- und Entladestroms der elektrischen Ausgangskapazität der Schnittstellenvorrichtung ermöglicht;
- eine Stufe zur Reduzierung der Analogabweichung der zweiten invertierten Signale und zur Kommutierung am Ausgang der Schnittstellenvorrichtung in einen Hochimpedanzzustand;
wobei die Stufe zur Reduzierung der Analogabweichung die vom ersten und vom zweiten Ausgang (E, F) der zweiten Inverterstufe gelieferten Signale empfängt und es auf Befehl ermöglicht, den Spannungswert des vom ersten Ausgang (E) der zweiten Inverterstufe gelieferten Signals zu senken und den Spannungswert des vom zweiten Ausgang (F) der zweiten Inverterstufe gelieferten Signals zu erhöhen.

2. Vorrichtung nach Anspruch 1, **dadurch gekennzeichnet,** daß die Steuerstufe umfaßt:
- einen ersten Inverter, der einen PMOS-Transistor (TP₁) und einen NMOS-Transistor (TN₁) umfaßt, die in Kaskade zwischen der Versorgungsspannung (Vcc) und der Bezugsspannung (Vss) angeschlossen sind und parallel durch das Steuersignal (e) gesteuert werden, wobei diese Transistoren im Bereich ihrer gemeinsamen Drain-Source-Elektrode ein erstes invertiertes Steuersignal (e₁) liefern;
- einen zweiten Inverter, der einen PMOS-Transistor (TP₂) und einen NMOS-Transistor (TN₂) umfaßt, die in Kaskade zwischen der Versorgungsspannung (Vcc) und der Bezugsspannung (Vss) angeschlossen sind und parallel durch das erste invertierte Steuersignal (e₁) gesteuert werden, wobei diese Transistoren im Bereich ihrer gemeinsamen Drain-Source-Elektrode ein zweites invertiertes Steuersignal (e₂) liefern;
- ein erstes Modul zum Invertieren des Eingangssignals (1), umfassend einen PMOS-Transistor (TP₅), einen NMOS-Transistor (TN₆) und einen NMOS-Transistor (TN₅), die in Kaskade zwischen der Versorgungsspannung (Vcc) und der Bezugsspannung (Vss) angeschlossen sind, wobei ferner ein PMOS-Transistor (TP₆) parallel zum PMOS-Transistor (TP₅) angeschlossen ist, wobei die gemeinsame Steuerelektrode des PMOS-Transistors (TP₅) und des NMOS-Transistors (TN₅) das Eingangssignal (I) empfängt und die gemeinsame Steuerelektrode des PMOS-Transistors (TP₆) und des NMOS-Transistors (TN₆) das zweite invertierte Steuersignal (e₂) empfängt, wobei der gemeinsame Drain-Source-Punkt (A) der PMOS-Transistoren (TP₅, TP₆) und des NMOS-Transistors (TN₆) einen der Ausgangsanschlüsse der Steuerstufe bildet;
- ein zweites Modul zum Invertieren des Eingangssignals (I), umfassend zwei PMOS-Transistoren (TP₃, TP₄) und einen NMOS-Transistor (TN₃), die in Kaskade zwischen der Versorgungsspannung (Vcc) und der Bezugsspannung (Vss) angeschlossen sind, wobei ferner ein NMOS-Transistor (TN₄) parallel zum NMOS-Transistor (TN₃) angeschlossen ist, wobei die gemeinsame Steuerelektrode des PMOS-Transistors (TP₃) und des NMOS-Transistors (TN₃) das erste invertierte Steuersignal (e₁) empfängt und die gemeinsame Steuerelektrode des PMOS-Transistors (TP₄) und des NMOS-Transistors (TN₄) das Eingangssignal (I) empfängt, wobei dergemeinsame Drain-Source-Punkt (B) des PMOS-Transistors (TP₄) und der NMOS-Transistoren (TN₄, TN₃) den anderen Ausgangsanschluß der Steuerstufe bildet.

3. Vorrichtung nach einem der Ansprüche 1 oder 2, **dadurch gekennzeichnet,** daß die erste Inverterstufe umfaßt:
- ein erstes Invertermodul, das durch einen PMOS-Transistor (TP₇) und einen NMOS-Transistor (TN₇) gebildet ist, die in Kaskade angeschlossen sind, wobei die gemeinsame Steuerelektrode der Transistoren an den Ausgangsanschluß des ersten Invertermoduls der Steuerstufe angeschlossen ist, wobei der gemeinsame Drain-Source-Punkt (C) des PMOS-Transistors (TP₇) und des NMOS-Transistors (TN₇) Logiksignale liefert, die komplementiert sind zu den Logiksignalen, welche vom Ausgangsanschluß des ersten Invertermoduls der Steuerstufe geliefert werden;
- ein zweites Invertermodul, das durch einen PMOS-Transistor (TP₈) und einen NMOS-Transistor (TN₈) gebildet ist, die in Kaskade angeschlossen sind, wobei die gemeinsame Steuerelektrode der Transistoren an den Ausgangsanschluß des zweiten Invertermoduls der Steuerstufe angeschlossen ist und der gemeinsame Drain-Source-Punkt (D) des PMOS-Transistors (TP₈) und des NMOS-Transistors (TN₈) Logiksignale liefert, die komplementiert sind zu den Logiksignalen, welche vom Ausgangsanschluß des zweiten Invertermoduls der Steuerstufe geliefert werden.

4. Vorrichtung nach einem der Ansprüche 1 und 3, **dadurch gekennzeichnet,** daß die zweite Inverterstufe umfaßt:
- ein erstes Invertermodul, das durch zwei parallel angeschlossene PMOS-Transistoren (TP₁₀, TP₁₁) und zwei parallel angeschlossene NMOS-Transistoren (TN₁₀, TN₁₁) gebildet ist, wobei jede Gruppe paralleler Transistoren in Kaskade zwischen der Versorgungsspannung (Vcc) und der Bezugsspannung (Vss) angeschlossen ist, wobei die gemeinsamen Steuerelektroden der PMOS- und NMOS-Transistoren die vom ersten Invertermodul der ersten Inverterstufe gelieferten komplementierten Logiksignale empfangen, wobei der gemeinsame Drain-Source-Punkt (E) der in Kaskade angeschlossenen Gruppen von parallelen Transistoren den ersten Ausgang der zweiten Inverterstufe bildet;
- ein zweites Invertermodul, das durch einen PMOS-Transistor (TP₉) und einen NMOS-Transistor (TN₉) gebildet ist, die in Kaskade zwischen der Versorgungsspannung (Vcc) und der Bezugsspannung (Vss) angeschlossen sind, wobei die gemeinsame Steuerelektrode des PMOS- und des NMOS-Transistors die vom zweiten Invertermodul der ersten Inverterstufe gelieferten komplementierten Logiksignale empfängt, wobei der gemeinsame Drain-Source-Punkt (F) des PMOS- und des NMOS-Transistors (TP₉, TN₉) den zweiten Ausgang der zweiten Inverterstufe bildet.

5. Vorrichtung nach einem der Ansprüche 1 bis 4, **dadurch gekennzeichnet,** daß die Stufe zur Verringerung der Analogpegelabweichung umfaßt:
- erste Kommutierungsmittel (41), die parallel zwischen dem ersten Ausgang (E) der zweiten Inverterstufe und der Bezugsspannung (Vss) angeschlossen sind, wobei es die ersten Kommutierungsmittel bei Befehl zum Leitendmachen der letzteren erlauben, den Analogspannungswert des vom ersten Ausgang (E) der zweiten Inverterstufe gelieferten Signals zu senken;
- zweite Kommutierungsmittel (42), die parallel zwischen dem zweiten Ausgang (F) der zweiten Inverterstufe und der Versorgungsspannung (Vcc) angeschlossen sind, wobei es die zweiten Kommutierungsmittel bei Befehl zum Leitendmachen der letzteren erlauben, den Ausgangsspannungswert des zweiten Ausgangs (F) der zweiten Inverterstufe auf den Wert der Versorgungsspannung (Vcc) zu erhöhen;
- Mittel zur Kommutierungssteuerung (43) der ersten und zweiten Kommutierungsmittel in Rückkopplung des Ausgangssignals (XXX), welche die im wesentlichen gleichzeitige Kommutierungssteuerung der ersten und zweiten Kommutierungsmittel ermöglichen, was es erlaubt, entweder den Analogpegel des vom ersten Ausgang (E) der zweiten Inverterstufe gelieferten Signals zu verringern, oder die Entladegeschwindigkeit der elektrischen Ausgangskapazität bei einem Übergang des Ausgangssignals vom Wert der Versorgungsspannung (Vcc) auf die Bezugsspannung zu erhöhen oder auch die Ausgangsstufe in einen Hochimpedanzausgang zu versetzen.

6. Vorrichtung nach Anspruch 5, **dadurch gekennzeichnet,** daß die Steuermittel (43) umfassen:
- einen Inverter, der durch zwei PMOS- (TP₁₆) und NMOS- (TN₁₇) Transistoren gebildet ist, die in Kaskade zwischen der Versorgungsspannung (Vcc) und der Bezugsspannung (Vss) angeschlossen sind, wobei die gemeinsamen Steuerelektroden der PMOS- und NMOS-Transistoren am Ausgang (XXX) der Ausgangsstufe angeschlossen sind und die Ausgangsspannung empfangen, wobei der gemeinsame Drain-Source-Punkt der Transistoren ein invertiertes Ausgangssignal liefert;
- einen Kommutierungsschaltkreis, der durch zwei PMOS-Transistoren (TP₁₄, TP₁₅) und zwei NMOS-Transistoren (TN₁₅, TN₁₆) gebildet ist, die in Kaskade zwischen der Versorgungsspannung (Vcc) und der Bezugsspannung (Vss) angeschlossen sind, wobei die gemeinsamen Steuerelektroden der PMOS- (TP₁₄) und NMOS- (TN₁₅) Transistoren das invertierte Ausgangssignal empfangen und die PMOS-(TP₁₅) und NMOS- (TN₁₆) Transistoren an ihrer Steuerelektrode das erste (e₁) bzw. das zweite (e₂) invertierte Steuersignal empfangen, wobei der gemeinsame Drain-Source-Punkt zwischen den PMOS- (TP₁₅) und NMOS- (TN₁₆) Transistoren es ermöglicht, das Steuersignal zur im wesentlichen gleichzeitigen Kommutierung der ersten und zweiten Kommutierungsmittel der Stufe zur Verringerung der Analogpegelabweichung zu liefern;
- einen NMOS-Transistor (TN₁₄), der zwischen dem gemeinsamen Drain-Source-Punkt zwischen den PMOS- (TP₁₅) und NMOS- (TN₁₆) Transistoren und der Bezugsspannung (Vss) angeschlossen ist, dessen Steuerelektrode das erste invertierte Steuersignal (E₁) empfängt.

7. Vorrichtung nach einem der Ansprüche 1 bis 6, **dadurch gekennzeichnet,** daß die Ausgangsstufe einen PMOS-Transistor (TP₁₇) und einen NMOS-Transistor (TN₁₈) umfaßt, die in Kaskade zwischen der Versorgungsspannung (Vcc) und der Bezugsspannung (Vss) angeschlossen sind, wobei der gemeinsame Drain-Source-Punkt der PMOS- und NMOS-Transistoren einen Ausgangsanschluß für die Ausgangsstufe und den Ausgangsanschluß der Vorrichtung bildet, wobei die Steuerelektrode des PMOS-Transistors (TP₁₇) an den ersten Ausgang (E) der zweiten Inverterstufe angeschlossen ist und die Steuerelektrode des NMOS-Transistors (TN₁₇) an den zweiten Ausgang (F) der zweiten Inverterstufe angeschlossen ist.

## Claims

1. An output interfacing device programmable among three states for a memory in CMOS technology, fed by a power supply voltage (Vcc) with respect to a reference voltage (Vss), successively comprising, in cascade:
- a stage for selective control of said interfacing device, receiving an input signal (I) and a control signal (e), which are delivered by the memory, said stage for selective control making it possible to generate, on two output ports (A,B), either complemented logic signals of said input signal (I), or distinct logic levels adapted to generate a high-impedance state at the output (XXX) of said output interfacing device;
- a first inverter stage receiving said logic signals delivered by the two output ports (A,B) of said control stage making it possible to generate first inverted logic signals on a first and a second output (C,D);
- a second inverter stage receiving said first inverted logic signals and making it possible to generate second inverted signals on a first and a second output (E,F);
- an output stage receiving signals delivered by the first and second output (E,F) of said second inverter stage, said output stage delivering an output signal (XXX) making it possible to fix and balance the current for charging and discharging said output capacitance of the said interfacing device;
- a stage reducing the analog difference between said second inverted signals and for switching the output of said output interfacing device into high-impedance state, said stage for reducing the analog difference receiving the signals delivered by the first and second outputs (E,F) of the second inverter stage and making it possible, under control, to lower the voltage value of the signal delivered by said first output (E) of the second inverter stage and to increase the voltage value of the signal delivered by said second output (F) of the second inverter stage.

2. The output interfacing device according to Claim 1, characterized in that said control stage comprises:
- a first inverter comprising a PMOS transistor (TP₁) and an NMOS transistor (TN₁) which are connected in cascade between said power supply voltage (Vcc) and said reference voltage (Vss) and which are controlled in parallel by said control signal (e), these transistors delivering a first inverted control signal (e₁) on their common drain-source electrode;
- a second inverter comprising a PMOS transistor (TP₂) and an NMOS transistor (TN₂) which are connected in cascade between said power supply voltage (Vcc) and said reference voltage (Vss) and which are controlled in parallel by said first inverted control signal (e₁), these transistors delivering a second inverted control signal (e₂) on their common drain-source electrode;
- a first module inverting said input signal (I), comprising a PMOS transistor (TP₅), an NMOS transistor (TN₆) and an NMOS transistor (TN₅) which are connected in cascade between said power supply voltage (Vcc) and said reference voltage (Vss), a PMOS transistor (TP₆) being furthermore connected in parallel with said PMOS transistor (TP₅), the common gate electrode of the PMOS (TP₅) and NMOS (TN₅) transistors receiving said input signal (I) and the common gate electrode of said PMOS (TP₆) and NMOS (TN₆) transistors receiving said second inverted control signal (e₂), the common drain-source point (A) of said PMOS (TP₅, TP₆) and NMOS (TN₆) transistors constituting one of said output ports of said control stage;
- a second module inverting said input signal (I), comprising two PMOS transistors (TP₃, TP₄) and an NMOS transistor (TN₃) which are connected in cascade between said power supply voltage (Vcc) and said reference voltage (Vss), an NMOS transistor (TN₄) being furthermore connected in parallel with said NMOS transistor (TN₃), the common gate electrode of said PMOS (TP₃) and NMOS (TN₃) transistors receiving said first inverted control signal (e₁) and the common gate electrode of the PMOS (TP₄) and NMOS (TN₄) transistors receiving said input signal (I), the common drain-source point (B) of the PMOS (TP₄) and NMOS (TN₄, TN₃) transistors constituting the other of said output ports of the control stage.

3. Device according to either of Claims 1 or 2, characterized in that said first inverter stage comprises:
- a first inverter module formed by a PMOS transistor (TP₇) and an NMOS transistor (TN₇) which are connected in cascade, the common gate electrode of said transistors being interconnected to said output port of said first inverter module of the control stage, the common drain-source point (C) of said PMOS (TP₇) and NMOS (TN₇) transistors delivering the complemented logic signals from the logic signals delivered by said output port of the first inverter module of said control stage;
- a second inverter module formed by a PMOS transistor (TP₈) and an NMOS transistor (TN₈) which are connected in cascade, the common gate electrode of said transistors being interconnected to said output port of said second inverter module of the control stage, and the common drain-source point (D) of said PMOS (TP₈) and NMOS (TN₈) transistors delivering complemented logic signals from the logic signals delivered by said output port of said second inverter module of the control stage.

4. The output interfacing device according to either of the Claims 1 and 3, characterized in that said second inverter stage comprises:
- a first inverter module formed by two PMOS transistors (TP₁₀, TP₁₁) which are connected in parallel and two NMOS transistors (TN₁₀, TN₁₁) which are connected in parallel, each set of transistors in parallel being connected in cascade between said power supply voltage (Vcc) and said reference voltage (Vss), the common gate electrodes of said PMOS and NMOS transistors receiving complemented logic signals delivered by said first inverter module of the first inverter stage, the common drain-source point (E) of said sets of transistors in parallel which are connected in cascade constituting said first output of the second inverter stage;
- a second inverter module formed by a PMOS transistor (TP₉) and an NMOS transistor (TN₉) which are connected in cascade between said power supply voltage (Vcc) and said reference voltage (Vss), the common gate electrode of said PMOS and NMOS transistors receiving complemented logic signals delivered by said second inverter module of the first inverter stage, the common drain-source point (F) of said PMOS and NMOS (TP₉, TN₉) transistors constituting the second output of the second inverter stage.

5. The output interfacing device according to one of the Claims 1 to 4, characterized in that said analog-level-difference reducing stage comprises:
- first switching means (41) connected in parallel between said first output (E) of the second inverter stage and said reference voltage (Vss), said first switching means making it possible, when they are turned on under control, to lower the value of the analog voltage of the signal delivered by said first output (E) of the second inverter stage;
- second switching means (42) connected in parallel between said second output of the second inverter stage and said power supply voltage (Vcc), said second switching means making it possible, when they are turned on under control, to increase the value of the output voltage of the second output (F) of the second inverter stage to the value of said power supply voltage (Vcc);
- means (43) for controlling the switching of said first and second switching means, in output signal (XXX) feedback mode, allowing substantially simultaneous control of switching of said first and second switching means, allowing thus either to reduce the analog level of the signal delivered by said first output (E) of the second inverter stage, or to increase the speed of discharge of the output capacitance upon a transition of said output signal from the value of said power supply voltage (Vcc) to the reference voltage, or to set said output stage to high-impedance output mode.

6. The output interfacing device according to Claim 5, characterized in that said control means include:
- an inverter formed by two PMOS (TP₁₆) and NMOS (TN₁₇) transistors which are connected in cascade between said power supply voltage (Vcc) and said reference voltage (Vss), the common gate electrodes of said PMOS and NMOS transistors being connected to said output (XXX) of said output stage and receiving said output voltage, the common drain-source point of said transistors delivering an inverted output signal;
- a switching circuit formed by two PMOS transistors (TP₁₄, TP₁₅) and two NMOS transistors (TN₁₅, TN₁₆) which are connected in cascade between said power supply voltage (Vcc) and said reference voltage (Vss), the common gate electrodes of the PMOS (TP₁₄) and NMOS (TN₁₅) transistors receiving said inverted output signal and the PMOS (TP₁₅) and NMOS (TN₁₆) transistors receiving, on their gate electrode, asid first (e₁) and said second (e₂) inverted control signal respectively, the common drain-source point between the PMOS (TP₁₅) and NMOS (TN₁₆) transistors making it possible to deliver said control signal for substantially simultaneous switching of the first and second switching means of the analog-level-difference reducing stage;
- an NMOS transistor (TN₁₄) connected between the common drain-source point between the PMOS (TP₁₅) and NMOS (TN₁₆) transistors and said reference voltage (Vss), the gate electrode of which receives said first inverted control signal (e₁).

7. The output interfacing device according to one of Claims 1 to 6, characterized in that said output stage comprises a PMOS transistor (TP₁₇) and an NMOS transistor (TN₁₈) which are connected in cascade between said power supply voltage (Vcc) and said reference voltage (Vss), the common drain-source point of said PMOS and NMOS transistors constituting an output terminal for said output stage and the output terminal of said device, the gate electrode of said PMOS transistor (TP₁₇) being connected to said first output of said second inverter stage and the gate electrode of said NMOS transistor (TN₁₇) being connected to said second output of the said second inverter stage.
